# DEMANDE DE BREVET EUROPEEN

(11) **EP 1 289 121 A1**
(43) Date de publication de la demande: **05.03.2003**
(21) Numéro de dépôt: 01203052.4
(22) Date de dépôt: 13.08.2001
(51) Int. Cl.: H03B 5/36, H03B 5/06

(54) **Circuit oscillateur à inverseur à consommation réduite**

(71) Demandeur: EM Microelectronic-Marin SA, 2074 Marin (CH)
(72) Inventeur: Pinchas, Novac, 2000 Neuchâtel (CH)
(74) Mandataire: Ravenel, Thierry Gérard Louis

(57) **Abrégé**

II est décrit un circuit oscillateur à inverseur (10) délivrant un signal de sortie alternatif (S_{OSC}) et comprenant un agencement parallèle, entre une borne d'entrée (A) et une borne de sortie (B), d'un moyen amplificateur inverseur (2,3), d'un résonateur (1) et d'une résistance (4), des premier et second condensateurs de charge (5, 6) étant respectivement connectés entre lesdites bornes d'entrée et de sortie (A, B), d'une part, et un potentiel d'alimentation (V_{SS}, V_{DD}, V_{R}), d'autre part.

Ce circuit oscillateur comprend en outre des moyens de commande (7a, 7b, 8) pour commander ledit moyen amplificateur inverseur de sorte qu'il présente une valeur de transconductance dite de démarrage (Gₘ) durant une phase de démarrage et une valeur de transconductance dite réduite (gₘ), inférieure à ladite valeur de transconductance de démarrage (Gₘ), en régime établi au terme de la phase de démarrage. Le circuit oscillateur comprend en outre des moyens (9, 90) pour lisser un saut d'amplitude du signal de sortie résultant du passage de ladite valeur de transconductance de démarrage à ladite valeur de transconductance réduite.

## Description

La présente invention concerne de manière générale un circuit oscillateur à inverseur à consommation réduite. Plus particulièrement, la présente invention concerne un circuit oscillateur à inverseur à relativement basse fréquence comportant préférablement un résonateur à quartz agencé pour vibrer selon un mode de vibration en torsion.

On connaît déjà de la demande de brevet européen EP 1 111 770 A1, au nom de Eta SA Fabriques d'Ebauches et EM Microelectronic-Marin SA, un dispositif oscillateur à quartz basse fréquence ayant un comportement thermique amélioré. Cette demande, incorporée ici par référence, décrit un circuit oscillateur de type à inverseur comportant un résonateur à quartz spécifique agencé pour vibrer selon un mode de vibration en torsion. Ce résonateur spécifique, qui est décrit dans l'article de MM. Roger Bourquin et Philippe Truchot, « Barreau de quartz vibrant en mode de torsion, Application aux capteurs », 6^{ème} Congrès Européen de Chronométrie (CEC), Bienne, 17-18 octobre 1996 (cité et incorporé par référence dans la demande de brevet européen susmentionnée), présente un unique angle de coupe défini par une rotation autour de l'axe cristallographique X du cristal de quartz, et comporte en particulier un mode fondamental de vibration en flexion non désiré se situant à une première fréquence et un mode fondamental de vibration en torsion désiré se situant à une deuxième fréquence supérieure à la première fréquence du mode fondamental de vibration en flexion non désiré.

Le circuit d'entretien des oscillations du résonateur est du type à inverseur. Afin d'assurer que le résonateur vibre selon le mode fondamental de vibration en torsion désiré, et non selon le mode fondamental de vibration en flexion non désiré, le circuit inverseur est conçu pour présenter une valeur de transconductance telle que les conditions limites de vibration (ou valeurs de transconductance critiques minimale et maximale) soient satisfaites pour le mode fondamental de vibration en torsion et non pour le mode fondamental de vibration en flexion.

Le comportement thermique du dispositif oscillateur ainsi conçu est ainsi grandement amélioré par rapport aux dispositifs oscillateurs conventionnels et présente notamment un comportement thermique similaire aux circuits employant des résonateurs dits de coupe AT pour une fréquence de fonctionnement nettement moins élevée (typiquement de 393 kHz pour le résonateur torsion comparé aux 4 MHz du résonateur de coupe AT) et donc une consommation comparativement inférieure.

Abstraction faite des avantages en terme de stabilité thermique, la consommation du circuit oscillateur décrit dans la demande européenne susmentionnée reste néanmoins comparativement plus élevée que celle des circuits oscillateurs basse fréquence conventionnels. La présente invention a donc pour but principal de proposer un circuit oscillateur de type à inverseur présentant une consommation plus réduite, ce circuit oscillateur comportant préférablement, mais pas nécessairement, un résonateur vibrant en torsion du type susmentionné.

On notera que l'on connaît déjà une solution permettant de réduire la consommation d'un circuit oscillateur à inverseur de la demande de brevet JP 60-64506 au nom de la société Fujitsu Ltd., déposée le 20 septembre 1983. Les figures 1a et 1b montrent deux schémas de principe de ce circuit oscillateur à inverseur, indiqué globalement par la référence numérique 10. Globalement, chacun des circuits oscillateurs illustrés correspond à un circuit oscillateur à inverseur classique comportant notamment l'agencement parallèle, entre des bornes d'entrée A et de sortie B, d'un moyen amplificateur inverseur 2, 3, d'un résonateur 1 et d'un élément résistif 4, dit résistance de contre-réaction, de valeur R_{F}. Des premier et second condensateurs de charge 5, 6 sont respectivement connectés entre les bornes d'entrée A et de sortie B, d'une part, et un potentiel d'alimentation, ici V_{SS}, d'autre part.

Ce circuit oscillateur 10 comporte en outre des moyens de commande 8 et un moyen de commutation 7 pour commander le moyen amplificateur inverseur 2, 3 de sorte qu'il présente une première valeur de transconductance durant une phase de démarrage et une seconde valeur de transconductance inférieure à la première valeur de transconductance en régime établi au terme de la phase de démarrage.

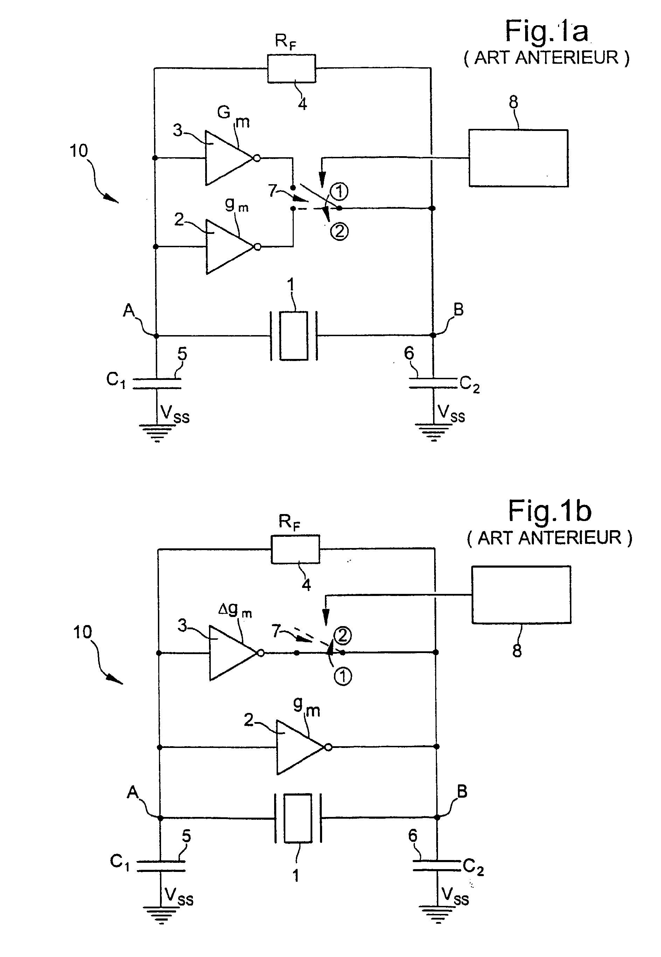

Plus précisément, le circuit oscillateur 10 de la figure 1a comprend un premier inverseur 2 ayant une première valeur de transconductance, désignée gₘ, et un second inverseur 3 ayant une seconde valeur de transconductance, désignée Gₘ, supérieure à la première valeur de transconductance gₘ. Le moyen de commutation 7 est disposé de manière à sélectivement connecter le premier inverseur 2 ou le second inverseur 3 entre les bornes d'entrée et de sortie A, B. Durant la phase de démarrage, le moyen de commutation 7 est en position « 1» de manière à connecter le second inverseur entre les bornes A et B. Dès lors que les oscillations sont stables, en régime dit établi, le moyen de commutation 7 passe en position « 2 » sous l'action des moyens de commande 8.

Le circuit oscillateur 10 de la figure 1b est sensiblement similaire au circuit de la figure 1a. Le second inverseur 3 présente ici uniquement une valeur de transconductance additionnelle ou complémentaire, désignée Δgₘ, qui est ajoutée à la valeur de transconductance gₘ du premier inverseur 2 lors de la phase de démarrage. Le moyen de commutation 7 est ainsi connecté de sorte que le second inverseur 3 est connecté en parallèle avec le premier inverseur 2 lors de la phase de démarrage (moyen de commutation 7 en position « 1 ») et déconnecté de ce second inverseur 2 en régime établi (moyen de commutation 7 en position « 2 »).

On notera que l'utilisation des solutions proposées dans le document japonais susmentionné peut avoir plusieurs inconvénients. En particulier, la diminution de la valeur de transconductance lors de la commutation au terme de la phase de démarrage a pour conséquence une diminution du courant (et donc de la consommation) qui se traduit également par une brusque diminution de l'amplitude du signal de sortie de l'oscillateur. Cette commutation du circuit oscillateur peut en particulier conduire à un fort amortissement des vibrations du résonateur qui peut éventuellement conduire à son arrêt total ou à une modification de son mode de vibration. En particulier, l'inventeur a pu constater que si la solution proposée dans le document japonais susmentionné était directement associée au résonateur susmentionné agencé pour vibrer en torsion, celle-ci conduisait soit à l'arrêt total du résonateur ou à une modification de son mode de vibration vers le mode fondamental de vibration en flexion non désiré.

On notera en outre que la diminution brusque de l'amplitude du signal de sortie de l'oscillateur peut également être un inconvénient pour les éléments périphériques associés au circuit oscillateur.

L'utilisation du principe énoncé dans la demande de brevet japonais susmentionnée, en particulier en association avec le circuit oscillateur de la demande de brevet européen EP 1 111 770 A1 mentionnée en préambule, requiert ainsi une attention toute particulière étant donné les conditions spécifiques auxquelles doit satisfaire le circuit oscillateur pour que le résonateur vibre selon le mode de vibration désiré.

Un autre but de la présente invention est donc de proposer un circuit oscillateur à consommation réduite qui soit aisément intégrable dans un système global, qui n'engendre pas de perturbations sur ce système et qui assure un maintien adéquat des vibrations du résonateur. En particulier, dans le cas où le circuit oscillateur emploie un résonateur à quartz vibrant en torsion du type susmentionné, on désire une solution garantissant que le mode de vibration en torsion est maintenu en sus de la réduction de consommation.

Encore un autre but de la présente invention et de pousser encore plus loin la réduction de consommation du circuit et de proposer une solution qui soit encore moins gourmande en énergie.

La présente invention a également pour but de proposer un procédé d'entretien des oscillations d'un résonateur du type susmentionné garantissant, d'une part, une réduction de la consommation, et, d'autre part, le maintien des oscillations du résonateur selon le mode fondamental de vibration en torsion désiré.

La présente invention a donc pour objet un circuit oscillateur à inverseur dont les caractéristiques sont énoncées dans la revendication indépendante 1.

La présente invention a également pour objet un procédé d'entretien des oscillations d'un résonateur du type susmentionné dont les caractéristiques sont énoncées dans la revendication indépendante 13.

Des modes de réalisation avantageux de la présente invention font l'objet des revendications indépendantes.

En se référant à la demande de brevet européen EP 1 111 770 A1 susmentionnée, on notera au sujet du résonateur spécifique agencé pour vibrer selon un mode de vibration en torsion que le circuit entretenant les vibrations du résonateur est agencé pour forcer le résonateur à vibrer selon le mode de vibration en torsion désiré et que, pour ce faire, la valeur de transconductance de l'inverseur est choisie supérieure à la valeur de transconductance maximale, désignée g_{m,max}, associée au mode de vibration en flexion non désiré. La transconductance étant notamment représentative du courant consommé par le circuit, on comprendra donc que le circuit consomme plus lorsque celui-ci est agencé pour forcer le résonateur à vibrer selon le mode de vibration en torsion que lorsque ce même circuit est agencé pour vibrer selon le mode de vibration en flexion classique.

Toutefois, selon la présente invention, l'inventeur a pu constater que la consommation du circuit peut être réduite une fois que le circuit oscillateur est démarré et que son signal de sortie est stable. En particulier, il est possible de faire démarrer le circuit pour que le résonateur vibre selon le mode de torsion désiré en satisfaisant les contraintes strictes déterminées par les valeurs de transconductances critiques définies dans la demande de brevet européen susmentionnée, et, au terme de cette phase de démarrage, réduire la consommation en garantissant que le résonateur vibre toujours selon ce mode de vibration en torsion. Cette réduction de la consommation est en partie obtenue en commutant le circuit, durant la phase dite de régime établi suivant la phase de démarrage, dans un autre état où celui-ci présente une valeur de transconductance réduite par rapport à la valeur de transconductance initiale définie pour le démarrage.

Avantageusement, l'inventeur a pu constater que la valeur de transconductance de l'inverseur peut éventuellement être réduite à une valeur inférieure à la valeur de transconductance critique en-dessous de laquelle les oscillations du résonateur selon le mode de vibration en torsion ne sont normalement plus garantie. L'inventeur a ainsi constaté que les valeurs de transconductances critiques sont essentiellement déterminantes lors de la phase de démarrage du résonateur. Par souci de sécurité, il est néanmoins parfaitement envisageable de garder la valeur de transconductance du circuit dans la gamme de valeurs évitant que le résonateur vibre selon le mode de vibration en torsion.

Outre la réduction de la consommation en régime établi, la présente invention assure également un démarrage rapide du circuit oscillateur par le choix d'une valeur de transconductance élevée durant cette phase initiale.

Selon l'invention, le circuit oscillateur est en outre équipé de moyens permettant de lisser l'amplitude de sortie du signal alternatif lors du passage de la phase de démarrage en régime établi, c'est-à-dire lors de la réduction de la valeur de transconductance du circuit. Ce lissage de l'amplitude du signal de sortie permet de limiter les effets de la commutation de la valeur de transconductance du circuit oscillateur et de garantir que les vibrations du résonateur ne soient pas amorties trop brusquement afin d'assurer que le résonateur continue à vibrer selon son mode de vibration désiré. D'autre part, ce lissage favorise l'intégration du circuit oscillateur dans un système global, les perturbations causées par la commutation du circuit oscillateur d'un état à l'autre étant minimisées.

Selon d'autres modes de réalisation de la présente invention, des moyens complémentaires sont utilisés pour réduire la consommation du circuit oscillateur en régime établi. Selon un premier de ces modes de réalisation, des éléments résistifs sont connectés en série dans le chemin d'alimentation du circuit inverseur. Selon un autre de ces modes de réalisation de l'invention, le circuit comporte en outre un régulateur de tension permettant d'abaisser la tension d'alimentation du circuit inverseur.

D'autres caractéristiques et avantages de la présente invention apparaîtront plus clairement à la lecture de la description détaillée qui suit, faite en référence aux dessins annexés donnés à titre d'exemples non limitatifs et dans lesquels :
- les figures 1a et 1b, déjà présentées, montrent deux schémas de principe d'un circuit oscillateur à inverseur décrit dans le document JP 60-64506 susmentionné ;
- la figure 2, montre un schéma général du circuit oscillateur à inverseur selon la présent invention ;
- la figure 3a illustre l'évolution au cours du temps de la valeur de transconductance du circuit oscillateur à inverseur de la figure 2, notamment durant la commutation d'une phase de démarrage vers une phase de régime établi ;
- la figure 3b illustre l'évolution au cours du temps de l'amplitude du signal d'oscillation délivré par le circuit oscillateur de la figure 2, notamment durant la commutation d'une phase de démarrage vers une phase de régime établi ;
- la figure 4 est un exemple détaillé d'un mode de réalisation du circuit oscillateur selon l'invention ;
- la figure 5a est un exemple de réalisation d'un circuit de génération d'un signal de commutation STARTUP permettant de commuter le circuit oscillateur de la figure 2 de la phase de démarrage à la phase de régime établi ; et
- la figure 5b est un diagramme illustrant l'évolution au cours du temps des signaux du circuit générateur de la figure 5a.

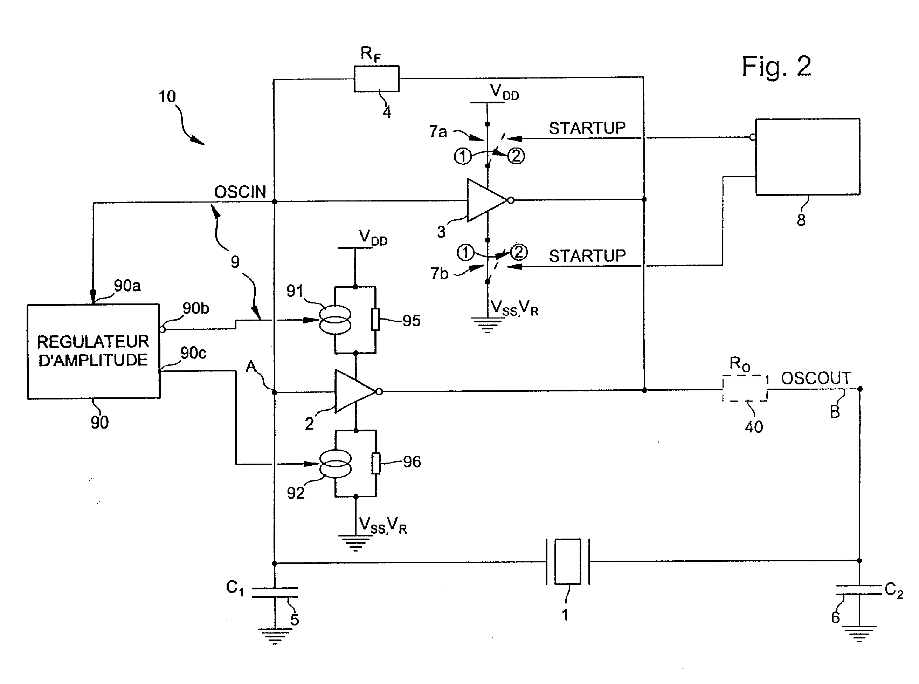

La figure 2 montre un schéma de principe général d'un circuit oscillateur de type à inverseur constituant un mode de réalisation préféré de la présente invention. Le circuit oscillateur à inverseur 10 illustré dans la figure 2 comprend typiquement l'agencement parallèle, entre des bornes d'entrée A et de sortie B, de moyens amplificateur inverseur comprenant des premier et second inverseurs 2, 3, d'un résonateur 1 et d'une résistance 4, des premier et second condensateurs de charge 5, 6 étant respectivement connectés entre lesdites bornes d'entrée et de sortie A, B, d'une part, et un potentiel d'alimentation, ici V_{SS}, d'autre part. Le circuit oscillateur 10 peut en outre comprendre un élément résistif additionnel 40, de valeur R_{O}, disposé entre la sortie des inverseurs 2, 3, d'une part, et le résonateur 1 ainsi que le condensateur de charge 6, d'autre part. Cet élément résistif optionnel 40 est notamment destiné à augmenter la stabilité du circuit oscillateur.

L'agencement des deux inverseurs 2, 3 est sensiblement analogue à l'agencement illustré dans la figure 1b, c'est-à-dire que le premier inverseur 2 est connecté en permanence entre les bornes d'entrée A et de sortie B, alors que le second inverseur 3 est susceptible d'être connecté ou déconnecté de ces bornes A, B sous l'action du circuit de commande 8. En l'occurrence, le second inverseur 3 est activé ou désactivé à l'aide de moyens de commutation (à savoir deux interrupteurs 7a et 7b contrôlés par le circuit de commande 8) placés dans le chemin d'alimentation de l'inverseur, entre les potentiels d'alimentation V_{DD} et V_{SS}.

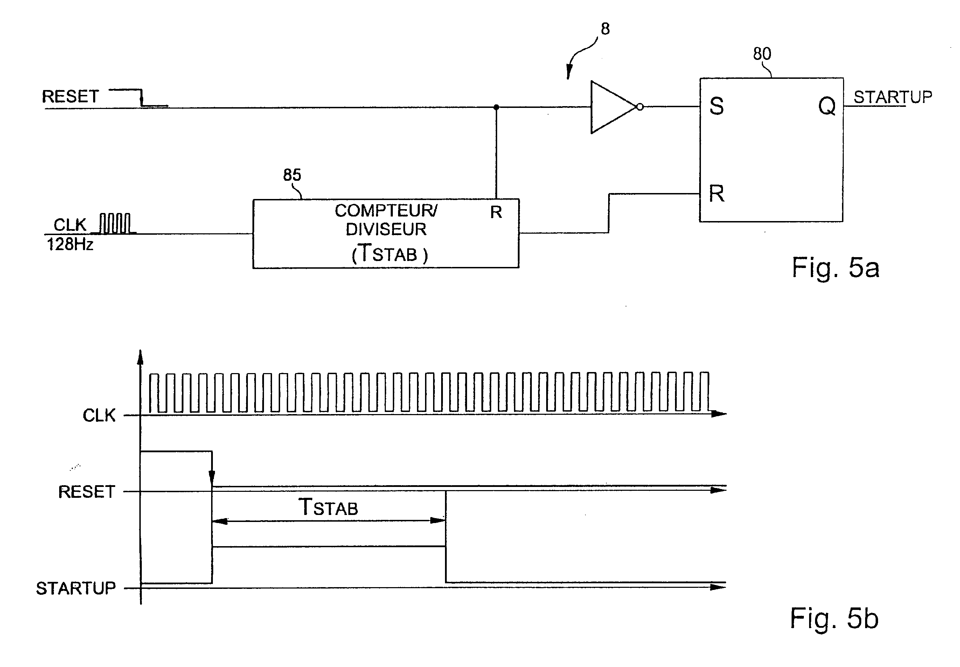

On notera que le second inverseur 3 pourrait alternativement être connecté ou déconnecté des bornes A et B au moyen d'un interrupteur connecté en série avec cet inverseur, par exemple au moyen d'une porte de transmission comprenant l'agencement parallèle d'un transistor n-MOS et d'un transistor p-MOS connectés l'un à l'autre par leurs terminaux de drain et de source comme cela est par exemple illustré dans la figure 5 du document japonais JP 60-64506 cité en préambule.

Le circuit oscillateur 10 comprend en outre des moyens permettant de lisser l'amplitude du signal de sortie alternatif, désigné S_{OSC}, lors de la commutation du circuit oscillateur au terme de la phase de démarrage. Ces moyens de lissage de l'amplitude du signal de sortie sont avantageusement réalisés sous la forme d'une boucle de réglage en amplitude désignée globalement par la référence numérique 9. Cette boucle de réglage en amplitude 9 est connectée, d'une part, sur l'une des bornes d'entrée et de sortie A, B du circuit oscillateur 10 (dans cet exemple, la borne d'entrée A), et, d'autre part, sur le premier inverseur 2.

La boucle de réglage en amplitude 9 comprend d'une part un circuit régulateur d'amplitude 90 et d'autre part au moins une source de courant contrôlée 91, 92 (préférablement deux) connectée dans le chemin d'alimentation de l'inverseur 2. Dans cet exemple, une borne d'entrée 90a du régulateur d'amplitude 90 est relié à la borne d'entrée A du circuit oscillateur, et deux bornes de sorties 90b, 90c sont respectivement connectées à des première et seconde sources de courant contrôlées 91, 92 placées de part et d'autre de l'inverseur 2 dans son chemin d'alimentation. Au titre de première amélioration, chaque source de courant contrôlée 91, 92 est en outre connectée en parallèle avec un élément résistif 95, respectivement 96. On reviendra ultérieurement sur l'utilité de ces éléments résistifs.

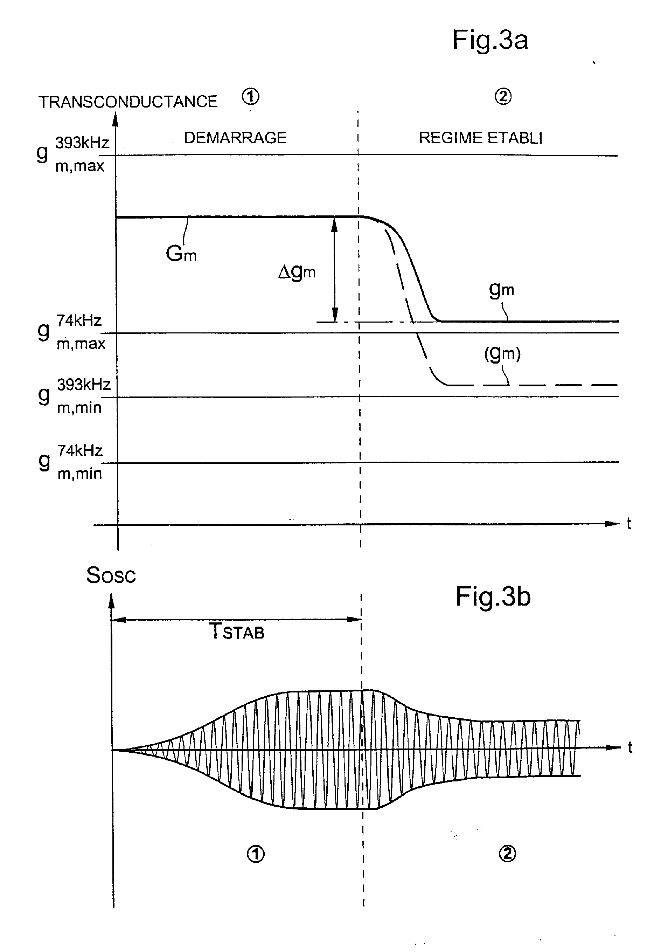

En se référant aux figures 3a et 3b, on va maintenant brièvement décrire le principe de fonctionnement du circuit oscillateur à inverseur selon la présente invention. La figure 3a illustre schématiquement l'évolution au cours du temps de la valeur de transconductance du circuit oscillateur selon l'invention. Dans la figure 3a, on a également illustré les conditions d'oscillation en termes de transconductances minimales (g_{m,min}) et maximales (g_{m,max}) pour les modes fondamentaux de vibration en flexion (à 74 kHz) et en torsion (393 kHz) du résonateur pris à titre d'exemple dans la demande de brevet européen EP 1 111 770 A1 susmentionnée. La figure 3b illustre schématiquement l'évolution correspondante du signal de sortie alternatif S_{OSC} de l'oscillateur.

Durant la phase de démarrage du circuit oscillateur (phase « 1 »), les deux inverseurs 2, 3 du circuit oscillateur sont connectés en parallèle de sorte que le circuit présente une valeur de transconductance globale, dite de démarrage, désignée Gₘ, de valeur élevée. On notera à ce titre que le choix d'une valeur de transconductance élevée durant la phase initiale permet de réduire le temps de démarrage du circuit oscillateur.

Afin de mettre le résonateur en vibration selon le mode fondamental de vibration en torsion désiré, la valeur de transconductance de démarrage Gₘ du circuit est sélectionnée de sorte que les conditions d'oscillations du mode désirés (à savoir le mode fondamental de vibration en torsion) soient satisfaites. Ces conditions sont satisfaites, dans l'exemple illustré, pour une valeur de transconductance de démarrage Gₘ comprise entre la valeur critique supérieure g_{m,max} du mode de vibration en flexion non désiré (à 74 kHz) et la valeur critique supérieure g_{m,max} du mode de vibration en torsion désiré (à 393 kHz).

En satisfaisant les conditions susmentionnées, le résonateur est mis en vibration selon le mode de vibration en torsion désiré. Comme illustré dans la figure 3b, l'amplitude du signal de sortie S_{OSC} augmente graduellement et la fréquence des oscillations tend vers un état stable. Par convention, on dira que les oscillations sont stabilisées au terme d'un intervalle de temps déterminé, désigné T_{STAB}.

Au terme de la phase de démarrage, dès lors que les oscillations du circuit oscillateur sont stabilisées (en régime dit établi, phase « 2 » dans les figures), le second inverseur 3 est désactivé de manière à réduire la valeur de transconductance du circuit à une valeur dite réduite, désignée gₘ, et ainsi réduire la consommation du circuit. Par souci de sécurité, la valeur de transconductance réduite gₘ est préférablement déterminée de sorte qu'elle satisfait toujours aux conditions d'oscillation strictes du mode de vibration en torsion désiré. L'inventeur a néanmoins pu constater que la valeur de transconductance peut être réduite à une valeur ne satisfaisant plus strictement les conditions d'oscillations susmentionnées. Dans l'exemple de la figure 3a, il est par exemple possible de réduire la valeur de transconductance du circuit à une valeur comprise entre la transconductance critique supérieure g_{m,max} du mode de vibration en flexion non désiré et la transconductance critique inférieure g_{m,min} du mode de vibration en torsion désiré, cette possibilité étant illustrée dans la figure 3a par la courbe en traits interrompus. On comprendra donc que la présente invention permet de réduire la consommation du circuit inverseur en-deçà du niveau de consommation défini par la condition d'oscillation inférieure, c'est-à-dire la valeur de transconductance critique supérieure g_{m,max} du mode de vibration en flexion non désiré (cette valeur étant typiquement supérieure à la transconductance critique inférieure g_{m,min} du mode de vibration en torsion désiré).

Selon la présente invention, la transition de la valeur de transconductance de démarrage Gₘ à la valeur de transconductance réduite gₘ n'est pas opérée de manière abrupte mais graduelle grâce à l'adjonction de la boucle de réglage en amplitude connectée sur le premier inverseur du circuit oscillateur. Il en résulte une diminution douce et progressive de l'amplitude du signal de sortie S_{OSC} comme illustré dans la figure 3b.

En se référant à nouveau à la figure 2, on notera que la consommation du circuit oscillateur peut encore être réduite par l'adjonction d'un élément résistif 95, 96 dans le chemin d'alimentation du premier inverseur 2 en parallèle avec chaque source de courant contrôlée 91, 92. L'adjonction de ces éléments résistifs a pour effet de limiter le courant maximum dans le chemin d'alimentation de l'inverseur 2 et donc de réduire encore la consommation du circuit oscillateur inverseur en régime établi.

Encore au titre d'amélioration, il est possible de réduire la tension d'alimentation aux bornes du circuit oscillateur inverseur, c'est-à-dire produire un potentiel d'alimentation intermédiaire, désigné V_{R}, compris entre les potentiels d'alimentation V_{DD} et V_{SS}.

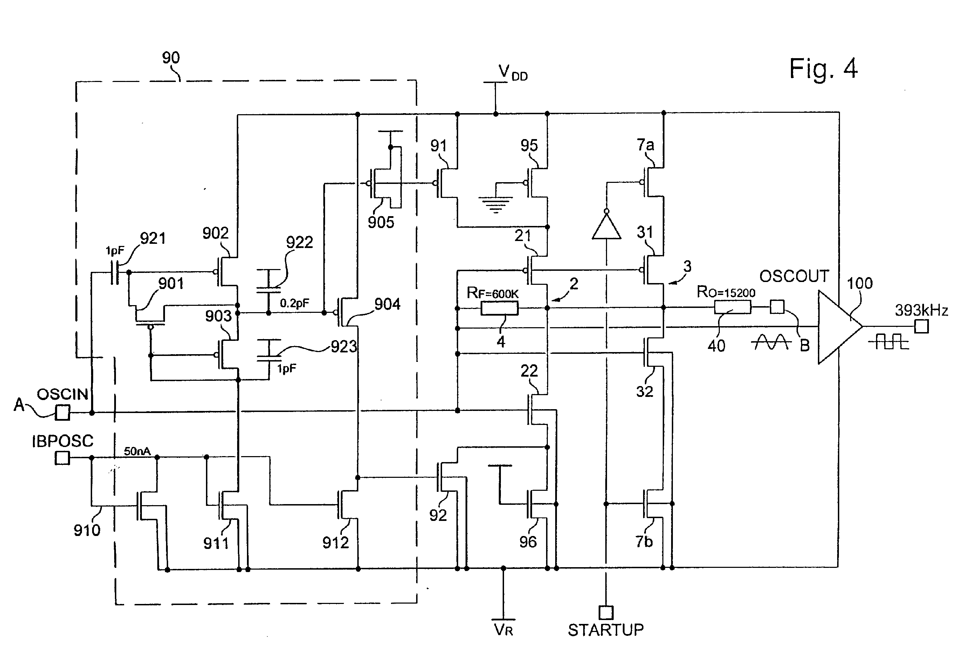

La figure 4 montre une réalisation détaillée du circuit oscillateur à inverseur de la figure 2. Par souci de clarté, le résonateur 1 (connecté entre les bornes A et B) ainsi que les condensateurs de charges 5 et 6 (respectivement connectés sur les bornes A et B) n'ont pas été représentés dans la figure 4.

Les premier et second inverseurs 2, 3 sont des inverseurs CMOS comprenant chacun un transistor p-MOS 21, resp. 31, dont le drain est connecté au drain d'un transistor n-MOS 22, resp. 32. Les grilles des transistors 21, 22, 31 et 32 sont connectées au même noeud et forment la borne d'entrée A du circuit oscillateur. Les drains des transistors 21, 22, 31, 32 sont connectés ensemble à la borne de sortie B, ici via l'élément résistif additionnel 40. L'élément résistif de contre-réaction 4 est connecté entre le noeud de connexion des grilles et le noeud de connexion des drains des transistors 21, 22, 31, 32. Le signal de sortie du circuit oscillateur (prélevé dans cet exemple sur la borne A) est appliqué de manière typique à l'entrée d'un étage de mise en forme 100 permettant de délivrer un signal de sortie carré.

La source du transistor p-MOS 31 du second inverseur 3 est connectée au potentiel d'alimentation haut V_{DD} par l'intermédiaire d'un autre transistor p-MOS formant l'interrupteur 7a. De même, la source du transistor n-MOS 32 du second inverseur 3 est connectée au potentiel d'alimentation bas (ici le potentiel d'alimentation intermédiaire V_{R}) par l'intermédiaire d'un autre transistor n-MOS formant l'interrupteur 7b. Un signal de commande désigné STARTUP est appliqué sur la grille du transistor n-MOS 7b ainsi que sur la grille du transistor p-MOS 7a (via un inverseur) afin de commander leur état de conduction et sélectivement activer ou désactiver le second inverseur 3.

La source du transistor p-MOS 21 du premier inverseur 2 est connectée au potentiel d'alimentation haut V_{DD} par l'intermédiaire d'un autre transistor p-MOS branché en configuration de résistance (potentiel de la grille amené à la masse), ce transistor p-MOS formant l'élément résistif 95 de la figure 2. Un transistor p-MOS formant la première source de courant contrôlée 91 est d'autre part interposé entre la source du transistor p-MOS 21 et le potentiel haut V_{DD} en parallèle avec le transistor 95 branché en résistance. De même, la source du transistor n-MOS 22 est connectée au potentiel d'alimentation bas V_{R} par l'intermédiaire d'un transistor n-MOS branché en configuration de résistance (potentiel de la grille amenée au potentiel haut) et formant l'élément résistif 96 de la figure 2. Un transistor n-MOS formant la seconde source de courant contrôlée 92 est interposé entre la source du transistor n-MOS 22 et le potentiel bas V_{R} en parallèle avec le transistor 96 branché en résistance.

Les transistors p-MOS 91 et n-MOS 92 formant les sources de courant contrôlées sont commandés par le circuit régulateur d'amplitude 90 dont on va maintenant brièvement décrire la structure. On notera que l'homme du métier pourra envisager d'autres configurations pour la réalisation de ce circuit régulateur d'amplitude et que la configuration illustrée ne saurait en conséquence être considérée comme une limitation de l'invention.

La borne d'entrée A du circuit oscillateur est appliquée sur un terminal d'un premier élément capacitif 921, l'autre terminal de cet élément capacitif 921 étant connecté d'une part au drain d'un premier transistor p-MOS 901 et, d'autre part, à la grille d'un second transistor p-MOS 902. La source de ce dernier est connectée au potentiel haut V_{DD} alors que son drain est connecté à la source du premier transistor p-MOS 901 ainsi qu'à la source d'un troisième transistor p-MOS 903. La grille ainsi que le drain de ce troisième transistor p-MOS 903 sont connectés à la grille du premier transistor 901. Le noeud de connexion entre le drain du transistor p-MOS 902 et les sources des transistors p-MOS 901 et 903 est relié à la grille d'un quatrième transistor p-MOS 904 dont la source est connectée au potentiel haut V_{DD}. Des second 922 et troisième 923 éléments capacitifs sont par ailleurs connectés par l'un de leurs terminaux respectivement sur le drain du transistor p-MOS 902 et sur le drain du transistor p-MOS 903, l'autre terminal de ces éléments capacitifs 922 et 923 étant connecté au potentiel d'alimentation haut V_{DD}.

La grille du transistor p-MOS formant la première source de courant contrôlée 91 est reliée à la grille du quatrième transistor p-MOS 904, un cinquième transistor p-MOS 905 branché en configuration de capacité (terminaux de drain et de source connectés au potentiel haut V_{DD}) étant connecté par sa grille sur cette même connexion entre les transistors p-MOS 91 et 904. La grille du transistor n-MOS formant la seconde source de courant contrôlée 92 est quant à elle reliée au drain du quatrième transistor p-MOS 904.

La polarisation des transistors du circuit régulateur d'amplitude 90 est assurée par un courant de polarisation IBPOSC qui est miroité dans la branche comportant le transistor p-MOS 903 et dans la branche comportant le transistor p-MOS 904 au moyen d'un miroir de courant comportant trois transistors n-MOS 910, 911 et 912, les transistors 911 et 912 des première et seconde branches de sortie du miroir de courant étant respectivement connectés en série avec le transistor p-MOS 903 et le transistor p-MOS 904.

La figure 5a montre un exemple de réalisation du circuit de commande 8 permettant de générer le signal de commande STARTUP destiné aux interrupteurs 7a et 7b. Ce circuit de commande 8, réalisé sous forme digitale, comprend essentiellement une bascule bistable S-R 80 et un compteur, ou diviseur, 85. Le compteur 85 est cadencé par un signal d'horloge CLK (à titre d'exemple purement illustratif et non limitatif, un signal d'horloge à 128 Hz dérivé du signal de sortie du circuit oscillateur). Un signal de mise à zéro RESET est appliqué sur une borne de remise à zéro du compteur 85 ainsi que sur la borne d'excitation S de la bascule 80, via un inverseur. Le compteur est agencé pour compter un nombre déterminé d'impulsions, à titre d'exemple purement illustratif, seize impulsions et défini ainsi un intervalle de temps de 16 x 1/128 = 125 ms dans cet exemple.

Comme illustré dans le diagramme de la figure 5b, le signal de commutation STARTUP passe ainsi au niveau logique haut durant un intervalle de temps déterminé de durée T_{STAB}. Durant cet intervalle de temps, le circuit oscillateur de la figure 2 est donc commuté dans le mode "haute transconductance" favorisant le démarrage rapide des oscillations. Dès lors que l'intervalle de temps est écoulé, le signal STARTUP passe au niveau logique bas, commutant ainsi le circuit oscillateur de la figure 2 dans le mode "basse transconductance" réduisant ainsi la consommation du circuit.

On comprendra que diverses modifications et/ou améliorations évidentes pour l'homme du métier peuvent être apportées au mode de réalisation décrit dans la présente description sans sortir du cadre de l'invention défini par les revendications annexées. Par exemple, la solution basée sur le principe de la figure 1a pourrait également être appliqué dans la mesure où la boucle de réglage en amplitude éviterait l'amortissement des oscillations du résonateur lors de la commutation de l'interrupteur.

## Revendications

1. Circuit oscillateur à inverseur (10) pour délivrer un signal de sortie alternatif (S_{OSC}), ce circuit oscillateur à inverseur (10) comprenant un agencement parallèle, entre une borne d'entrée (A) et une borne de sortie (B), d'un moyen amplificateur inverseur (2,3), d'un résonateur (1) et d'une résistance (4), des premier et second condensateurs de charge (5, 6) étant respectivement connectés entre lesdites bornes d'entrée et de sortie (A, B), d'une part, et un potentiel d'alimentation (V_{SS}, V_{DD}, V_{R}), d'autre part,
ce circuit oscillateur à inverseur (10) compreant en outre des moyens de commande (7a, 7b, 8) pour commander ledit moyen amplificateur inverseur (2, 3) de sorte qu'il présente une valeur de transconductance dite de démarrage (Gₘ) durant une phase de démarrage et une valeur de transconductance dite réduite (gₘ), inférieure à ladite valeur de transconductance de démarrage (Gₘ), en régime établi au terme de ladite phase de démarrage,
**caractérisé en ce que** le circuit oscillateur à inverseur (10) comprend en outre des moyens (9, 90) pour lisser un saut d'amplitude du signal de sortie (S_{OSC}) résultant du passage de ladite valeur de transconductance de démarrage (Gₘ) à ladite valeur de transconductance réduite (gₘ).

2. Circuit oscillateur à inverseur (10) selon la revendication 1, **caractérisé en ce que** ledit moyen amplificateur inverseur (2, 3) comprend un premier inverseur (2) ayant une première valeur de transconductance, connecté en permanence entre lesdites bornes d'entrée et de sortie (A, B), et un second inverseur (3) ayant une seconde valeur de transconductance,
et **en ce que** lesdits moyens de commande (7a, 7b, 8) comprennent des moyens de commutation (7a, 7b) agencés pour connecter ledit second inverseur (3) entre lesdites bornes d'entrée et de sortie (A, B) durant ladite phase de démarrage et pour déconnecter ce second inverseur (3) en régime établi au terme de ladite phase de démarrage.

3. Circuit oscillateur à inverseur (10) selon la revendication 2, **caractérisé en ce que** lesdits premier et second inverseurs (2, 3) sont des inverseurs CMOS comprenant chacun l'agencement, entre des premier (V_{DD}) et second (V_{SS}; V_{R}) potentiels d'alimentation définissant un chemin d'alimentation, d'un transistor p-MOS (21, 31) et d'un transistor n-MOS (22, 32) dont les terminaux de drain sont connectés en commun et forment ladite borne de sortie (B) et dont les terminaux de grille sont connectés en commun et forment ladite borne d'entrée (A),
les terminaux de source desdits transistors p-MOS (21, 31) et n-MOS (22, 32) étant respectivement connectés, directement ou indirectement, au premier (V_{DD}) et au second (V_{SS} ; V_{R}) potentiels d'alimentation.

4. Circuit oscillateur à inverseur (10) selon l'une quelconque des revendications 2 ou 3, **caractérisé en ce que** lesdits moyens pour lisser le saut d'amplitude du signal de sortie (S_{OSC}) comprennent une boucle de réglage en amplitude (9) connectée sur ledit premier inverseur (2) et assurant le réglage de l'amplitude dudit signal de sortie alternatif (S_{OSC}) en régime établi.

5. Circuit oscillateur à inverseur (10) selon la revendication 4, **caractérisé en ce que** ladite boucle de réglage en amplitude (9) comprend un circuit régulateur d'amplitude (90) connecté sur l'une desdites bornes d'entrée et de sortie (A, B) et délivrant un signal de commande à au moins une source de courant (91, 92) disposée dans ledit chemin d'alimentation du premier inverseur (2).

6. Circuit oscillateur à inverseur (10) selon la revendication 5, **caractérisé en ce que** au moins un élément formant résistance (95, 96) est branché en série dans le chemin d'alimentation dudit premier inverseur (2) en parallèle avec ladite au moins une source de courant (91, 92).

7. Circuit oscillateur à inverseur (10) selon la revendication 7, **caractérisé en ce que** ledit au moins un élément formant résistance (95, 96) est un transistor MOS branché en résistance entre le terminal de source de l'un desdits transistor p-MOS (21) ou n-MOS (22) dudit premier inverseur (2) et l'un desdits potentiels d'alimentation (V_{SS} ; V_{R} ; V_{DD}) correspondant.

8. Circuit oscillateur à inverseur (10) selon l'une quelconque des revendications 2 à 7, **caractérisé en ce que** ledit second inverseur (3) est sélectivement connecté ou déconnecté desdites bornes d'entrée et de sortie (A, B) au moyen de premier et second interrupteurs (7a, 7b) branchés en série dans le chemin d'alimentation dudit second inverseur (3),
ledit premier interrupteur (7a) étant un transistor p-MOS connecté par ses terminaux de drain et de source entre le terminal de source du transistor p-MOS (31) dudit second inverseur (3) et ledit premier potentiel d'alimentation (V_{DD}),
ledit second interrupteur (7b) étant un transistor n-MOS connecté par ses terminaux de drain et de source entre le terminal de source du transistor n-MOS (32) dudit second inverseur (3) et ledit second potentiel d'alimentation (V_{SS} ; V_{R}).

9. Circuit oscillateur à inverseur (10) selon l'une quelconque des revendications précédentes, **caractérisé en ce que** lesdits moyens de commande (8) comprennent des moyens pour générer un signal de commutation (STARTUP) dudit moyen amplificateur inverseur (2, 3) au terme d'un intervalle de temps déterminé (T_{STAB}) débutant lors du démarrage dudit circuit oscillateur.

10. Circuit oscillateur à inverseur (10) selon l'une quelconque des revendications 2 à 9, **caractérisé en ce qu'**il comprend en outre un circuit régulateur de tension pour alimenter au moins ledit premier inverseur (2) avec une tension d'alimentation réduite (V_{DD} - V_{R}).

11. Circuit oscillateur à inverseur (10) selon l'une quelconque des revendications précédentes, **caractérisé en ce que** ledit résonateur (1) est un résonateur à quartz présentant au moins un mode fondamental de vibration en torsion, et **en ce que** ladite valeur de transconductance de démarrage (Gₘ) est déterminée de sorte que le résonateur (1) est mis en vibration selon ledit mode fondamental de vibration en torsion au moins lors de ladite phase de démarrage.

12. Circuit oscillateur à inverseur (10) selon la revendication 11, **caractérisé en ce que** ledit résonateur (1) présente un unique angle de coupe défini par une rotation d'un angle déterminé (t) autour de l'axe cristallographique X dudit quartz, de sorte que ledit résonateur comporte au moins un mode fondamental de vibration en flexion non désiré à une première fréquence et ledit mode fondamental de vibration en torsion désiré à une seconde fréquence supérieure à ladite première fréquence,
ladite valeur de transconductance de démarrage (Gₘ) étant déterminée de sorte que ledit résonateur (1) est mis en vibration selon ledit mode fondamental de vibration en torsion désiré et non selon ledit mode fondamental de vibration en flexion non désiré.

13. Procédé pour entretenir les vibrations d'un résonateur (1) et produire un signal de sortie alternatif (S_{OSC}) au moyen d'un circuit oscillateur à inverseur (10) comprenant un moyen amplificateur inverseur (2, 3), ce résonateur (1) présentant un premier mode de vibration, non désiré, à une première fréquence et un second mode de vibration, désiré, à une seconde fréquence,
**caractérisé en ce que** ce procédé comprend:
- une étape de démarrage consistant à commander ledit moyen amplificateur inverseur (2, 3) de sorte qu'il présente une valeur de transconductance dite de démarrage (Gₘ) durant ladite étape de démarrage, cette valeur de transconductance de démarrage (Gm) étant déterminée de sorte que ledit résonateur (1) est mis en vibration selon ledit second mode de vibration désiré ; et
- une étape de commutation consistant à commander ledit moyen amplificateur inverseur (2, 3) de sorte qu'il présente une valeur de transconductance dite réduite (gₘ), inférieure à ladite valeur de transconductance de démarrage (Gₘ), dès lors que ledit résonateur (1) est en régime établi.

14. Procédé selon la revendication 13, **caractérisé en ce que** ladite étape de commutation consiste également à lisser le saut d'amplitude dudit signal de sortie alternatif (S_{OSC}) résultant du passage de ladite valeur de transconductance de démarrage (Gₘ) à ladite valeur de transconductance réduite (gₘ).

15. Procédé selon la revendication 13 ou 14, **caractérisé en ce que** ledit premier mode de vibration non désiré est un mode de vibration en flexion et **en ce que** ledit second mode de vibration désiré est un mode de vibration en torsion à une fréquence supérieure à la fréquence dudit mode de vibration en flexion.
